# EUROPEAN PATENT APPLICATION

(11) **EP 4 553 891 A1**
(43) Date of publication of application: **14.05.2025**
(21) Application number: 24205861.8
(22) Date of filing: 10.10.2024
(51) Int. Cl.: H01L 23/15, H01L 23/498, H01L 23/66

(54) **METHOD OF FABRICATING RADIO-FREQUENCY MULTI-LAYER CIRCUITS ON FUSED SILICA**

(30) Priority: 09.11.2023 US 202363597543 P
(71) Applicant: GE Aviation Systems Limited, Bishops Cleeve Cheltenham Gloucestershire GL52 8SF (GB)
(72) Inventor: MACDONALD, Robert James, Niskayuna, NY 12309 (US); IANNOTTI, Joseph, Niskayuna, NY 12309 (US); RUFFALO, Renner, Niskayuna, NY 12309 (US)
(74) Representative: Openshaw & Co.

(57) **Abstract**

A method of fabricating a radio-frequency multi-layer circuit includes perforating a silicon wafer to form a plurality of perforations, forming a plurality of vias spaced apart by the plurality of perforations, oxidizing the silicon wafer to provide a silicon oxide wafer, after forming the plurality of vias, filling the plurality of perforations with a fused silica layer to convert the silicon oxide wafer into a fused silica wafer, depositing within the plurality of vias and between the plurality of vias a metal layer connector to connect the plurality of vias, and bonding two or more fused silica wafers together such that the vias of the two or more fused silica wafers are connected to each other to form a radio-frequency circuit.

## Description

### TECHNICAL FIELD

The present disclosure relates generally to radio-frequency circuits and, in particular, to a method of fabricating radio-frequency multi-layer circuits on fused silica and circuits fabricated using the method.

### BACKGROUND

A radio-frequency (RF) circuit is a type of analog circuit operating in a radio-frequency range suitable for wired or wireless transmission. An RF circuit can use inductive elements to tune a resonant circuit operation around a specific carrier radio-frequency. RF circuits are used in many applications including signal communication, such as in broadcast radio and television, mobile or wireless phones, etc. According to U.S. Institute of Electrical and Electronics Engineers (IEEE), the RF range can be divided into many RF bands, including, but not limited to, HF (0.003 GHz to 0.03 GHz), VHF (0.03 GHz to 0.3 GHz), UHF (0.3 GHz to 1 GHz), ... , Ku (12 GHz to 18 GHz), K (18 GHz to 27 GHz), Ka (27 GHz to 40 GHz), V (40 GHz to 75 GHz), W (75 GHz to 110 GHz), and G (110 GHz to 300 GHz).

### BRIEF DESCRIPTION OF THE DRAWINGS

The foregoing and other features and advantages will be apparent from the following, more particular, description of various exemplary embodiments, as illustrated in the accompanying drawings, wherein like reference numbers generally indicate identical, functionally similar, and/or structurally similar elements.
FIG. 1A is a schematic top view of a silicon wafer, according to an embodiment of the present disclosure.
FIG. 1B is a schematic cross section of the silicon wafer along line 1B-1B shown in FIG. 1A, according to an embodiment of the present disclosure.
FIG. 2 is a zoomed-in area of FIG. 1B showing an enlarged perforation of a plurality of perforations, according to an embodiment of the present disclosure.
FIG. 3 is a schematic representation of a perforation after oxidation of the silicon wafer, according to an embodiment of the present disclosure.
FIG. 4 is a schematic representation of the perforation after oxidation of the silicon wafer, according to an embodiment of the present disclosure.
FIG. 5 is a schematic top view of the fused silica wafer having a plurality of vias, according to an embodiment of the present disclosure.
FIG. 6 is a schematic top view of the fused silica wafer having the plurality of vias and connected by a metal layer connector, according to an embodiment of the present disclosure.
FIG. 7 is a cross section of two fused silica wafers bonded to each other, according to an embodiment of the present disclosure.
FIG. 8 is a cross section of three fused silica wafers bonded to each other, according to an embodiment of the present disclosure.

### DETAILED DESCRIPTION

Additional features, advantages, and embodiments of the present disclosure are set forth or apparent from a consideration of the following detailed description, drawings, and claims. Moreover, both the foregoing summary of the present disclosure and the following detailed description are exemplary and intended to provide further explanation without limiting the scope of the disclosure as claimed.

Various embodiments of the present disclosure are discussed in detail below. While specific embodiments are discussed, this is done for illustration purposes only. A person skilled in the relevant art will recognize that other components and configurations may be used without departing from the spirit and the scope of the present disclosure.

Here and throughout the specification and claims, range limitations are combined, and interchanged. Such ranges are identified and include all the sub-ranges contained therein unless context or language indicates otherwise. For example, all ranges disclosed herein are inclusive of the endpoints, and the endpoints are independently combinable with each other.

Embodiment of the present disclosure provide a method of fabricating multilayer RF circuits on fused silica for operation in the RF range, for example, K, Ka, V, W, and/or G radio-frequency bands. The method is used to fabricate silica circuitry, a printed circuit (PC) board for RF applications. The method allows for the attachment of monolithic Microwave Integrated Circuits (MMIC) and other RF devices, including RF waveguides.

In an embodiment, a silicon wafer is finely perforated using an industry standard deep silicon etch tool (DSE). The wafer is then oxidized, and the perforated silicon wafer is converted to fused silica (FS) to provide a fused silica wafer. Gaps within the fused silica wafer are filled with chemical vapor deposited fused silica. In this way, fused silica from 10 mm to 100 mm can be fabricated on a silicon handle. Simultaneously, vias are formed. The vias are then metalized, using known techniques in the art that are standard to the semiconductor industry, such as sputter deposition, electroplating, and photolithography. The fused silica wafers are then bonded and thinned, producing multilayer structures. The fused silica wafers can have MMIC bonded structures. The fused silica wafer can also be interconnected to standard circuitry for the control of a phased array antenna, for example.

Current methods use thin, fragile 100 mm fused silica wafers, and attempts to process the fused silica wafer in this state often fail. The present method by using deep silicon etching followed by conversion into fused silica can extend the range of devices that can be fabricated, reduce overall cost, and improve yield.

In general, silicon wafers have good microfabrication properties, but poor RF properties. On the other hand, fused silica wafers have good RF properties (e.g., for manufacturing high frequency RF circuits such as circuits used in antennas), but poor microfabrication properties. A fused silica wafer has a lower dielectric loss. A dielectric constant of a material can be expressed mathematically as a combination of a real dielectric part and an imaginary dielectric part. Fused silica has a thermally stable real dielectric part. This characteristic may be useful when an RF circuit is subject to temperature swings that could shift pass bands, for example. Multi-layer fused silica circuits are, however, difficult to form. Current conventional methods consist of layering very thin, fragile fused silica wafers together. However, this may be challenging as the fused silica wafers are mechanically fragile, and can crack or break.

RF circuits, based on fused silica that can be used for active electronically scanned array antenna (AESA), are being fabricated on fused silica circuits. For example, the active electronically scanned antenna (AESA) may include vital sensor systems providing situational awareness, and stealth and electronic warfare capabilities. The RF circuits based on fused silica can also be used as insensitive high Q-filters for antenna front end band switching owing to the temperature stable dielectric constant of fused silica. Q-filters are compact multistage low-pass filters that are used to reject noise in RF signals that are input into temperature sensitive electronic circuits. This same operation of layering a wafer is relatively easy with silicon, which can be micromachined. However, silicon has poor RF properties, particularly, in the 100 GHz to 200 GHz band, which is susceptible to loss. Therefore, converting the microfabricated silicon wafer into a fused silica wafer would provide wafers with good RF properties while allowing micromachining and layering the wafer in the silicon state.

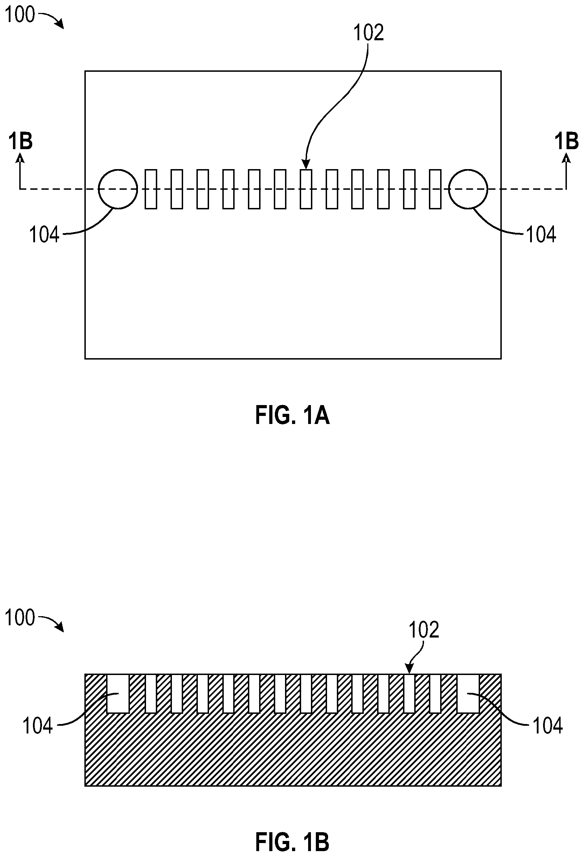

Referring now to the drawings, FIG. 1A is a schematic top view of a silicon wafer, according to an embodiment of the present disclosure. FIG. 1B is a schematic cross section of the silicon wafer along line 1B-1B shown in FIG. 1A, according to an embodiment of the present disclosure. As shown in FIGS. 1A and 1B, the silicon wafer 100 has a plurality of perforations 102 and a plurality of vias 104 (two vias are shown in FIGS. 1A and 1B). The plurality of perforations 102 and the plurality of vias are created by etching, for example, by a lithography method, followed by a deep silicon etching technique (DSE). The plurality of perforation 102 are used as structural areas of support to provide or to run an electrical conductor between the plurality of vias 104. The plurality of perforations 102 provide support to traces of conductive material (not shown in FIGS. 1A and 1B) connecting the plurality of vias 104.

The silicon wafer 100 having the plurality of perforations 102 shown in FIGS. 1A and 1B is converted to a fused silica wafer 200 using thermal oxidation, as will be discussed in further detail in the paragraphs below. When silicon is oxidized, silicon is consumed (45% of the fused silica thickness is consumed silicon). Oxidation is performed at 1100 degrees Celsius, so that material flaws and stress are eliminated.

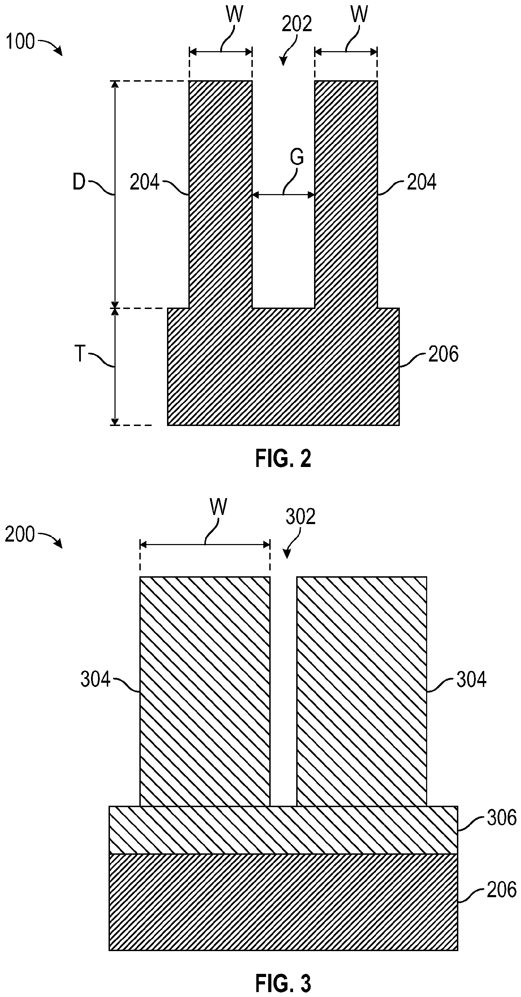

FIG. 2 is a zoomed-in area of FIG. 1B showing an enlarged perforation 202 of the plurality of perforations 102, according to an embodiment of the present disclosure. The perforation 202 is surrounded by silicon features 204. The perforation 202 forms a gap G between two neighboring silicon features 204. In an embodiment, the dimension of the gap G is between about 3.1 µm and about 4.1 µm, for example, approximately 3.6 µm. In an embodiment, the width W of the silicon features 204 is between about 1.5 µm and about 3.0 µm, for example, approximately 2.7 µm. The silicon features 204 are support by silicon substrate 206. In an embodiment, a thickness T of the substrate is about between about 250 µm and about 750 µm, for example, approximately 500 µm. A depth D of the perforation 202 is between about 10 µm and about 200 µm, for example, approximately 80 µm. After oxidation of the silicon wafer 100, silicon oxide grows on the silicon features 204 and the silicon substrate 206.

FIG. 3 is a schematic representation of the perforation 202 after oxidation of the silicon wafer 100, according to an embodiment of the present disclosure. The silicon features 204 converted into silicon oxide features 304 and the perforation 202 becomes perforation 302. The gap G of the perforation 302 is reduced and is narrower than the gap G of the perforation 202, due to silicon oxide build up on the walls of the perforation 302. In an embodiment, the width W of the silicon oxide features 304 is about 6 µm. In an embodiment, the silicon oxide features 304 are spaced apart by about 0.3 µm. Therefore, the gap G of the perforation 302 is about 0.3 µm. As shown in FIG. 3, a portion of the silicon substrate 206 is also converted into silicon oxide layer 306. In this way, silicon oxide surrounds the perforation 302.

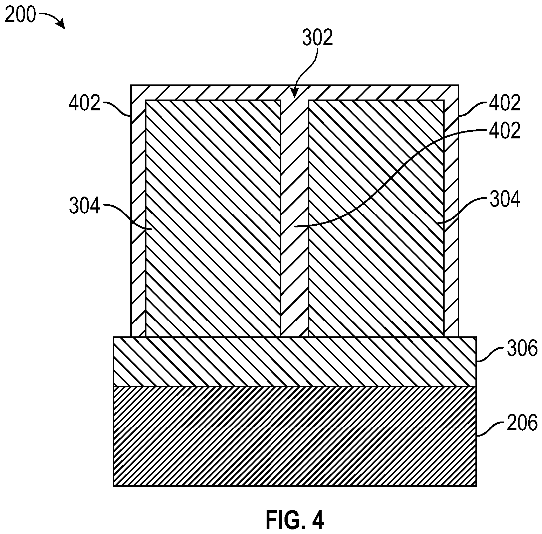

FIG. 4 is a schematic representation of the perforation 202 after oxidation of the silicon wafer 100, according to an embodiment of the present disclosure. After forming the silicon oxide in the silicon oxide features 304, the perforation 302 is filled with chemical vapor deposition (CVD) of fused silica layer 402. CVD can be used to deposit thin fused silica layers.

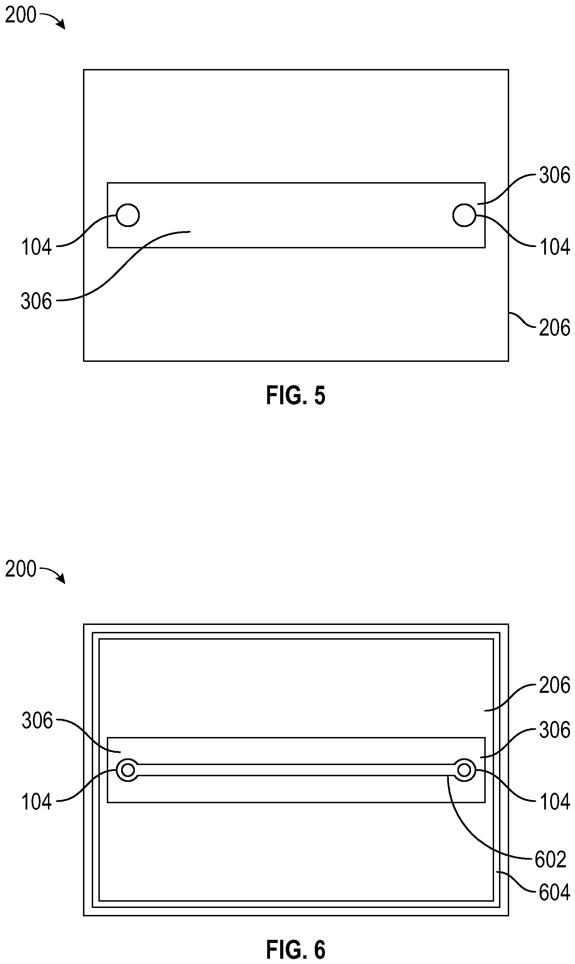

FIG. 5 is schematic top view of the fused silica wafer 200 having a plurality of vias 104, according to an embodiment of the present disclosure. The fused silica wafer 200 includes the silicon substrate 206 and the silicon oxide layer substrate. The plurality of vias 104 are formed through the silicon oxide layer 306.

FIG. 6 is a schematic top view of the fused silica wafer 200 having a plurality of vias 104 connected by metal layer connector 602, according to an embodiment of the present disclosure. As shown in FIG. 6, a metal layer connector is deposited within the plurality of vias 104. The metal layer connector 602 also connects the plurality of vias 104. The metal layer connector 602 includes metal traces. The metal layer connector 602 is deposited using the following procedure. TiAu seed is sputtered, a pattern is defined where a metal is not desired to be deposited, and gold is electroplated to fill vias. The electroplated gold can be pure gold or a gold compound such as AuSn for solderability later. The electroplated gold fills or coats the plurality of vias 104 to form wirebond pads (e.g., for die attach, MMICs), and to provide a bonding area for wafer level thermo-compression bonding. A grounding metal connector 604 is also provided. For example, the grounding metal connector 604 can be provided at the periphery of the fused silica wafer, as shown in FIG. 6.

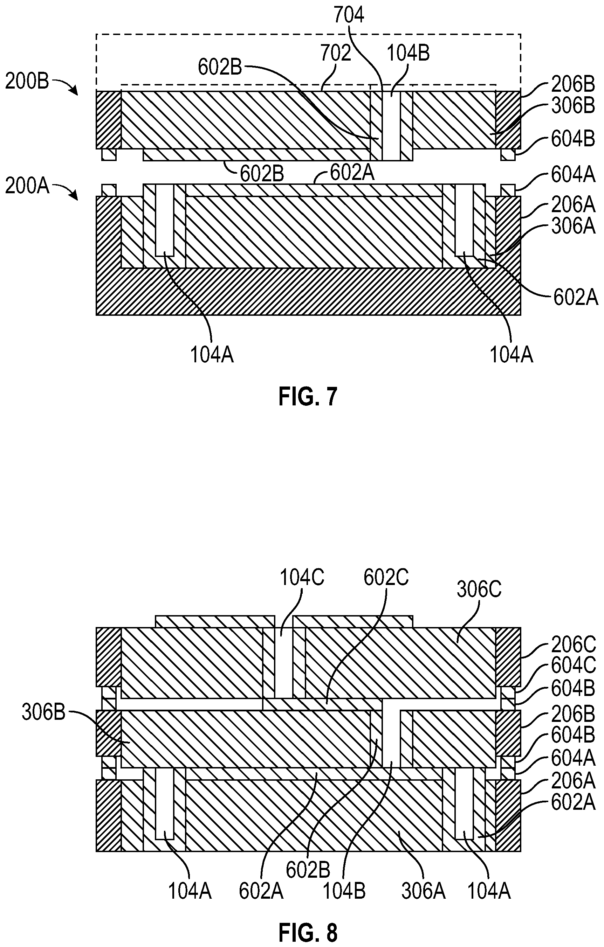

FIG. 7 is a cross section of two fused silica wafers bonded to each other, according to an embodiment of the present disclosure. As shown in FIG. 7, a first fused silica wafer 200A, similar to fused silica wafer 200, includes silicon substrate 206A. On top of the silicon substrate 206A is provided the silicon dioxide layer 306A formed by oxidation of the silicon substrate 206A. The first fused silica wafer 200A also includes a metal layer connector 602A connecting a plurality of vias 104A that are provided within the first fused silica wafer 200A. The first fused silica wafer 200A also includes grounding metal connector 604A. In addition, as shown in FIG. 7, a second fused silica wafer 200B, similar to fused silica wafer 200, includes silicon substrate 206B. On top of the silicon substrate 206B is provided the silicon dioxide layer 306B formed by oxidation of the silicon 206B. The second fused silica wafer 200B also includes a metal layer connector 602B connected to one or more vias 104B that are provided within the second fused silica wafer 200B.

As shown in FIG. 7, the second fused silica wafer 200B includes, for example, only one via 104B and the metal layer connector 602B extending from the via 104. The second fused silica wafer 200B does not include two vias 104B connected to each other using the metal layer connector 602B as in the first fused silica wafer 200A because, in the second fused silica wafer 200B, the one via 104B and the metal layer connector 602B are in fact connected to the corresponding plurality of vias 104A and the metal layer connector 602A of the first fused silica wafer 200A.

In order to establish this connection, the first fused silica wafer 200A and the second fused silica wafer 200B are bonded to each other using, for example, thermocompression. When the first fused silica wafer 200A and the second fused silica wafer are bonded to each other, the metal layer connector 602B fuses with the metal layer connector 602A. As a result, in this example, the one via 104B is connected to the plurality of vias 104A through metal layer connector 602A and metal layer connector 6022B that are fused together. In addition, the grounding metal connector 604A of the first fused silica wafer 200A is also connected to the grounding metal connector 604B of second fused silica wafer 200B. In this example, the second fused silica wafers 200B is placed on top of the first fused silica wafers 200A.

Following bonding of the first fused silica wafer 200A to the second fused silica wafer 200B, a top surface 702 of the second fused silica wafer 200B is ground to reveal the via 104B. The second fused silica wafer 200B is ground to remove a silicon substrate 206B and a metal layer connector portion 704 deposited inside the via 104B to reveal the via 104B. The grinding will allow bonding yet a third fused silica wafer 200C (shown in FIG. 8) on top of the second fused silica wafer.

FIG. 8 is a cross section of three fused silica wafers bonded to each other, according to an embodiment of the present disclosure. As shown in FIG. 8, the third fused silica wafer 200C includes, for example, via 104C and the metal layer connector 602C extending from the via 104C. Similar to the second fused silica wafer 200B, the third fused silica wafer 200C also does not include two vias 104C connected to each other using the metal layer connector 602C as in the first fused silica wafer 200A because, in the third fused silica wafer 200C, the one via 104C and the metal layer connector 602C are connected to the corresponding via 104B and the metal layer connector 602B of the second fused silica wafer 200B.

In order to establish this connection, the third fused silica wafer 200C is bonded to the second fused silica wafer 200B using thermocompression, for example. When the third fused silica wafer 200C and the second fused silica wafer 20B are bonded to each other, the metal layer connector 602C connects to the metal layer connector within the via 104B. As a result, in this example, the via 104B is connected to the via 104C through metal layer connector 602C. In addition, the grounding metal connector 604C of the third fused silica wafer 200C is also connected to the grounding metal connector 604B of the second fused silica wafer 200B. In this example, the third fused silica wafers 200C is placed on top of the second fused silica wafer 200B. As a result, the plurality of vias 104A of the first fused silica wafer 200A are connected to each other and to the via 104B of the second fused silica wafer 200B and to the via 104C of the third fused silica wafer 200C. After bonding the third fused silica wafer 200C to the second fused silica wafer 200B, the silicon substrate 206A ("handle wafer"), on which is built the first fused silica wafer 200A, can be removed, as shown in FIG. 8. The process of grinding and bonding fused silica wafers can be repeated as desired to stack a plurality of fused silica wafers to build an RF device or an RF multilayer circuit, such as an RF antenna, or the like.

Further aspects are provided by the subject matter of the following clauses.

A method of fabricating a radio-frequency multi-layer circuit including perforating a silicon wafer to form a plurality of perforations, forming a plurality of vias spaced apart by the plurality of perforations, oxidizing the silicon wafer to provide a silicon oxide wafer, after forming the plurality of vias, filling the plurality of perforations with a fused silica layer to convert the silicon oxide wafer into a fused silica wafer, depositing, within the plurality of vias and between the plurality of vias, a metal layer connector to connect the plurality of vias, and bonding two or more fused silica wafers together such that the vias of the two or more fused silica wafers are connected to each other to form a radio-frequency circuit.

The method of the previous clause, wherein perforating includes etching the silicon wafer to form the plurality of perforations.

The method of any preceding clause, wherein etching the silicon wafer comprises using a deep silicon etch tool.

The method of any preceding clause, wherein a radio-frequency range of the radio-frequency circuit comprises K, Ka, V, W, and G radio-frequency bands.

The method of any preceding clause, wherein oxidizing the silicon wafer comprises converting silicon features surrounding the plurality of perforations into silicon oxide features.

The method of any preceding clause, wherein a gap between the silicon oxide features defined by the plurality of perforations is reduced by the oxidizing.

The method of any preceding clause, wherein the depositing within the plurality of vias and between the plurality of vias the metal layer connector to connect the plurality of vias comprises depositing gold or a gold compound as the metal layer connector.

The method of any preceding clause, wherein the depositing within the plurality of vias and between the plurality of vias the metal layer connector to connect the plurality of vias comprises sputtering a gold compound, defining a pattern where a metal is not desired to be deposited, and electroplating gold or a gold compound within the plurality of vias and between the plurality of vias.

The method of any preceding clause, further including depositing a grounding metal connector.

The method of any preceding clause, wherein depositing the grounding metal connector comprises depositing the grounding metal connector at a periphery of the fused silica wafer.

The method of any preceding clause, wherein bonding two or more fused silica wafers together such that the vias of the two or more fused silica wafers are connected to each other comprises bonding a first fused silica wafer to a second fused silica wafer such that a plurality of vias of the first fused silica wafer are connected to each other and to a via in the second fused silica wafer through a metal layer connector provided in the first fused silica wafer and a metal layer connector provided in the second fused silica wafer.

The method of any preceding clause, wherein the first fused silica wafer and the second fused silica wafer are bonded together using thermocompression.

The method of any preceding clause, wherein, when the first fused silica wafer and the second fused silica wafer are bonded to each other, the metal layer connector in the second fused silica wafer fuses with the metal layer connector in the first fused silica wafer.

The method of any preceding clause, wherein, when the first fused silica wafer and the second fused silica wafer are bonded to each other, a grounding metal connector in the second fused silica wafer is in contact with a grounding metal connector in the first fused silica wafer.

The method of any preceding clause, further including grinding a surface of the second fused silica wafer to reveal a via in the second fused silica wafer and to remove a silicon substrate and a metal layer connector portion deposited inside the via.

The method of any preceding clause, further including bonding a third fused silica wafer to the second fused silica wafer to form a stack of interconnected fused silica wafers.

The method of any preceding clause, wherein bonding the third fused silica wafer to the second fused silica wafer comprises connecting a metal layer connector in the third fused silica wafer to the metal layer connector in the second fused silica wafer to connect a via in the third fused silica wafer to a via in the second fused silica wafer.

A radio-frequency circuit comprising a plurality of fused silica wafers, each of said fused silica wafers manufactured by: a method that includes perforating a silicon wafer to form a plurality of perforations, forming a plurality of vias spaced apart by the plurality of perforations, oxidizing the silicon wafer to provide a silicon oxide wafer, after forming the plurality of vias, filling the plurality of perforations with a fused silica layer to form convert the silicon oxide wafer into a fused silica wafer, and depositing within the plurality of vias and between the plurality of vias a metal layer connector to connect the plurality of vias.

The radio-frequency circuit of the preceding clause, wherein the plurality of fused silica wafers are bonded together such that the vias of the plurality of fused silica wafers are connected to each other to form the radio-frequency circuit.

The radio-frequency circuit of any preceding clause, wherein the plurality of fused silica wafers are bonded together such that vias in the plurality of fused silica wafers are connected to each other.

Although the foregoing description is directed to the preferred embodiments of the present disclosure, other variations and modifications will be apparent to those skilled in the art and may be made without departing from the spirit or the scope of the disclosure. Moreover, features described in connection with one embodiment of the present disclosure may be used in conjunction with other embodiments, even if not explicitly stated above.

## Claims

1. A method of fabricating a radio-frequency multi-layer circuit, the method comprising:
perforating a silicon wafer to form a plurality of perforations;
forming a plurality of vias spaced apart by the plurality of perforations;
oxidizing the silicon wafer to provide a silicon oxide wafer, after forming the plurality of vias;
filling the plurality of perforations with a fused silica layer to convert the silicon oxide wafer into a fused silica wafer;
depositing, within the plurality of vias and between the plurality of vias, a metal layer connector to connect the plurality of vias; and
bonding two or more fused silica wafers together such that the vias of the two or more fused silica wafers are connected to each other to form a radio-frequency circuit.

2. The method according to claim 1, wherein a radio-frequency range of the radio-frequency circuit comprises K, Ka, V, W, and G radio-frequency bands.

3. The method according to claim 1 or 2, wherein the depositing, within the plurality of vias and between the plurality of vias, the metal layer connector to connect the plurality of vias comprises (i) depositing gold or a gold compound as the metal layer connector, or (ii) sputtering a gold compound, defining a pattern where a metal is not desired to be deposited, and electroplating gold or a gold compound within the plurality of vias and between the plurality of vias.

4. The method according to any preceding claim, wherein the perforating includes etching the silicon wafer to form the plurality of perforations, and optionally, etching the silicon wafer comprises using a deep silicon etch tool.

5. The method according to any preceding claim, wherein oxidizing the silicon wafer comprises converting silicon features surrounding the plurality of perforations into silicon oxide features, and optionally, a gap between the silicon oxide features defined by the plurality of perforations is reduced by the oxidizing.

6. The method according to any preceding claim, further comprising depositing a grounding metal connector, and optionally, depositing the grounding metal connector comprises depositing the grounding metal connector at a periphery of the fused silica wafer.

7. The method according to any preceding claim, wherein bonding two or more fused silica wafers together such that the vias of the two or more fused silica wafers are connected to each other comprises bonding a first fused silica wafer to a second fused silica wafer such that a plurality of vias of the first fused silica wafer are connected to each other and to a via in the second fused silica wafer through a metal layer connector provided in the first fused silica wafer and a metal layer connector provided in the second fused silica wafer.

8. The method according to claim 7, wherein the first fused silica wafer and the second fused silica wafer are bonded together using thermocompression.

9. The method according to claim 7 or 8, wherein, when the first fused silica wafer and the second fused silica wafer are bonded to each other, (i) the metal layer connector in the second fused silica wafer fuses with the metal layer connector in the first fused silica wafer, or (ii) a grounding metal connector in the second fused silica wafer is in contact with a grounding metal connector in the first fused silica wafer.

10. The method according to any of claims 7 to 9, further comprising grinding a surface of the second fused silica wafer to reveal a via in the second fused silica wafer and to remove a silicon substrate and a metal layer connector portion deposited inside the via.

11. The method according to any of claims 7 to 10, further comprising bonding a third fused silica wafer to the second fused silica wafer to form a stack of interconnected fused silica wafers.

12. The method according to claim 11, wherein bonding the third fused silica wafer to the second fused silica wafer comprises connecting a metal layer connector in the third fused silica wafer to the metal layer connector in the second fused silica wafer to connect a via in the third fused silica wafer to a via in the second fused silica wafer.

13. A radio-frequency circuit comprising a plurality of fused silica wafers, each of said fused silica wafers manufactured by a method comprising:
perforating a silicon wafer to form a plurality of perforations;
forming a plurality of vias spaced apart by the plurality of perforations;
oxidizing the silicon wafer to provide a silicon oxide wafer, after forming the plurality of vias;
filling the plurality of perforations with a fused silica layer to convert the silicon oxide wafer into a fused silica wafer; and
depositing, within the plurality of vias and between the plurality of vias, a metal layer connector to connect the plurality of vias.

14. The radio-frequency circuit according to claim 13, wherein the plurality of fused silica wafers are bonded together such that the vias of the plurality of fused silica wafers are connected to each other to form the radio-frequency circuit.

15. The radio-frequency circuit according to claim 14, wherein the plurality of fused silica wafers are bonded together such that vias in the plurality of fused silica wafers are connected to each other.
